# EUROPEAN PATENT APPLICATION

(11) **EP 4 852 238 A1**
(43) Date of publication of application: **09.12.2026**
(21) Application number: 26182402.3
(22) Date of filing: 01.06.2026
(51) Int. Cl.: H01S 5/12, H01S 5/10, H01S 5/026, H01S 5/028

(54) **LASER DEVICE, LASER ARRANGEMENT AND METHOD FOR MANUFACTURING THE LASER DEVICE**

(30) Priority: 05.06.2025 US 202519229919
(71) Applicant: Fraunhofer-Gesellschaft zur Förderung der angewandten Forschung e.V., 80686 München (DE)
(72) Inventor: Möhrle, Martin, 10587 Berlin (DE)
(74) Representative: Stöckeler, Ferdinand

(57) **Abstract**

The laser device comprises an active layer structure configured for generating laser light based on an injection current and arranged between a semiconductor substrate and an integrally formed grating structure, wherein the integrally formed grating structure comprises a first grating section and a second grating section which are arranged laterally adjacent to each other, which commonly share the active layer structure, and which have the same uniform grating period, wherein the first and second grating sections of the integrally formed grating structure each comprise an index coupling grating; and wherein the first grating section is arranged to have a first effective coupling coefficient and the second grating section is arranged to have a second effective coupling coefficient, wherein the first effective coupling coefficient is smaller than the second effective coupling coefficient; a cladding structure arranged such that the integrally formed grating structure is arranged between the active layer structure and the cladding structure; a first facet and a second facet, which are arranged at opposing end surfaces of the active layer structure, wherein the first facet and the second facet each comprise an anti-reflection (AR) coating; and a contact structure arranged for providing the injection current to the active layer structure next to the first grating section.

## Description

### Technical Field

The present application relates to a laser device having a combined DBR-DFB-laser configuration, to a laser arrangement having such a laser device, and to a method for manufacturing such a laser device. The laser device combines a DFB (DFB = Distributed Feedback) functionality and DBR (DBR = Distributed Bragg Reflection) functionality for achieving a very high single mode yield based on an effective mode selection mechanism.

### Background of the Invention

DFB lasers are key devices for optical data transmission in telecom systems, within data centers, within high performance computing systems, for sensing applications, as light source within EMLs (EMLs = Electro-absorption modulated lasers) and for photonic integrated chips.

Regarding low production cost, the single mode yield of these DFB lasers after fabrication should be very high. In particular for DFB laser arrays the single mode yield should be close to 100%. Phase shifted index coupled DFBs or complex coupled DFBs using an AR/AR facet coating configuration (AR = anti-reflection) fulfill this requirement [1.1].

However, in both (above) cases a big part of the light is emitted at the back facet which reduces the usable front side slope efficiency and thus also the wall-plug efficiency (also called electrical-to-optical efficiency) of the devices. To partially overcome this problem DFB-SOA combinations (SOA = Semiconductor Optical Amplifier) are often used so that high output power is achieved at the front facet [1.2]. A Semiconductor Optical Amplifier is a device that amplifies an optical signal directly without first converting it to an electrical signal. It's similar in structure to a laser diode but is designed specifically to amplify incoming light rather than generate its own coherent light.

To achieve a maximum front side output power an AR/HR coating (HR = high reflection) is commonly used in order to significantly reduce the light emission from the back facet of the DFB lasers and also to achieve low threshold currents. Due to the arbitrary phase of the (cleaved) and HR-coated back facet the single mode yield then is substantially reduced to values in the 50...70% range which increases the production cost of such DFB and EML components.

Within the last years, three main approaches have been proposed to tackle this problem and at least to achieve reasonably high single mode yield with AR/HR coated DFBs.

Use of partially corrugated DFB gratings [1.3, 1.4]: By using single section or multi section partially corrugated gratings the internal intensity distribution can be optimized so that the effect of the arbitrary HR coated facet phase can be strongly reduced resulting in a high single mode yield of the lasers.

Use of reconstruction equivalent chirp (REC) gratings [1.5, 1.6]: By using this novel sampled grating approach a single mode yield of about 95% can be achieved for AR/HR coated devices. However even these two very promising approaches cannot completely avoid the influence of the DFB back facet phase.

Use of a DBR-DFB-Configuration [1.7]: In this case a quarter lambda phase-shifted DFB is monolithically integrated with a DBR sharing the same active layer. Both facets here AR coated. The DBR here effectively acts as a HR facet: the DFB light is injected into the unpumped DBR so that it becomes transparent and then acts as a reflector. DFB and DBR have identical coupling strength and the single mode yield here is relatively high. However, at high coupling coefficients / high operation currents there is a high risk of spatial hole burning in the DFB because of the intensity peak at the position of the quarter lambda phase shift.

Spatial hole burning is a phenomenon that may occur in Distributed Feedback (DFB) lasers, where the spatial distribution of the light intensity inside the laser cavity becomes non-uniform due to the interaction between the light and the periodic structure of the grating. This effect can influence the output characteristics and performance of the laser, especially in terms of mode stability and threshold current.

With regard to exemplary publications on the state of the art, reference is made to the publication documents (references) at the end of the description.

Thus, a target of the present invention is to propose an improved laser device having a specific DBR-DFB-laser configuration showing a close 100% single mode yield but preventing any spatial hole burning.

Therefore, there is particular need for providing laser devices having improved operational characteristics.

Such a need is fulfilled by the laser device according to independent claim 1, a laser arrangement having the laser device according to claims 16 and 17 and according to a method for manufacturing such a laser device according to independent claim 18.

Further specific implementation of the present inventive concept for the laser device, the laser arrangement and the manufacturing method are defined in the respective dependent claims.

### Summary

According to an embodiment, a laser device, comprises (-) an active layer structure configured for generating laser light based on an injection current and arranged between a semiconductor substrate and an integrally formed grating structure, wherein the integrally formed grating structure comprises a first grating section and a second grating section which are arranged laterally adjacent to each other, which commonly share the active layer structure, and which have the same uniform grating period; wherein the first and second grating sections of the integrally formed grating structure each comprise an index coupling grating; and wherein the first grating section is arranged to have a first effective coupling coefficient and the second grating section is arranged to have a second effective coupling coefficient, wherein the second effective coupling coefficient is smaller than the first effective coupling coefficient; (-) a cladding structure arranged such that the integrally formed grating structure is arranged between the active layer structure and the cladding structure; (-) a first facet and a second facet, which are arranged at opposing end surfaces of the active layer structure, wherein the first facet and the second facet each comprise an anti-reflection (AR) coating; and (-) a contact structure arranged for providing the injection current to the active layer structure next to the first grating section.

According to an embodiment, the first and the second grating section are arranged to have the same uniform grating or grating period for providing, during an operating condition of the laser device, a laser light which is in phase in the active layer structure along the first and the second grating section. Thus, due to the uniform grating of the integrally formed grating structure, there is no phase shift of the propagating laser light along the active layer structure in the first and the second grating section and in between the first and the second grating section.

According to an embodiment, a laser arrangement comprises the above the laser device, wherein the laser device is monolithically integrated with at least one of: an electro-absorption modulator (EAM), a semiconductor optical amplifier (SOA), an electro-absorption modulator and a semiconductor optical amplifier (SOA), a Mach-Zehnder modulator (MZM), or a photonic integrated circuit.

According to an embodiment, a laser arrangement comprises the above the laser device, wherein the laser device is hybridly integrated with a photonic integrated circuit.

According to an embodiment, a method for manufacturing a laser device comprises (-) arranging an active layer structure on a semiconductor substrate; (-) integrally forming a grating structure on the active layer structure such that the integrally formed grating structure comprises a first grating section and a second grating section which are arranged laterally adjacent to each other, which commonly share the active layer structure, and which have the same uniform grating period, and the first and second grating sections of the integrally formed grating structure each comprise an index coupling grating; wherein the first grating section is arranged to have a first effective coupling coefficient and the second grating section is arranged to have a second effective coupling coefficient, wherein the second effective coupling coefficient is smaller than the first effective coupling coefficient; (-) arranging a cladding structure on the integrally formed grating structure such that the integrally formed grating structure is arranged between the active layer structure and the cladding structure; (-) arranging a first facet and a second facet arranged at laterally opposing ends of the active layer structure wherein the first facet and the second facet each comprise an anti-reflection coating; and (-) arranging a contact structure, wherein the contact structure comprises (at least) two contact regions arranged on (vertically) opposing main surface regions of an active section of the laser device.

According to an embodiment, the method further comprises the step of forming the first and the second grating section to have the same uniform grating period for providing, during an operating condition of the laser device, a laser light which is in the active layer structure along the first and the second grating section in phase.

According to an embodiment, the integrally formed grating structure is obtained by a common or single electron beam writing process. According to an embodiment, the integrally formed grating structure is defined within a single electron beam (Ebeam) grating field.

The inventive concept of the present invention provides an improved DBR-DFB-laser configuration for a laser device resulting in a close to 100% single mode yield but preventing any spatial hole burning by using a new (specific) mode selection mechanism.

Thus, the laser device having the specific DBR-DFB-laser configuration enables to significantly improve the single mode yield of the AR/HR facet coated index coupled DFB laser devices and EMLs (EMLs = Electro-absorption modulated lasers).

In the following description, embodiments are discussed in detail, however, it should be appreciated that the embodiments provide many applicable concepts that can be embodied in a wide variety of the field of laser devices. The specific embodiments discussed are merely illustrative of specific ways to implement and use the present concept, and do not limit the scope of the embodiments.

### Brief Description of the Drawings/Figures

Embodiments of the present inventive concept may be subsequently described in detailed referring to the appended drawings in which:
- Fig. 1: shows a schematic cross-sectional view of a laser device according to an embodiment of the present inventive concept;
- Figs. 2a-c: show a simulated DBR reflection spectrum, the corresponding DFB transmission spectrum, and the resulting (stable) single mode operation spectrum of the laser device according to embodiments of the present inventive concept;
- Fig. 3: shows a schematic cross-sectional view of a laser device according to an embodiment of the present inventive concept;
- Fig. 4: shows a schematic plane view of a laser device according to an embodiment of the present inventive concept;
- Fig. 5: shows a schematic cross-sectional view of a laser device according to an embodiment of the present inventive concept;
- Fig. 6a-b: show schematic block diagrams of a laser arrangement having the laser device according to an embodiment of the present inventive concept; and
- Fig. 7: shows a schematic block diagram of a method for manufacturing a laser device according to an embodiment of the present inventive concept.

### Detailed Description of the Invention

Before discussing the present embodiments in further detail using the drawings, it is pointed out that in the figures and the specification identical elements and elements having the same functionality and/or the same technical or physical effect are usually provided with the same reference numbers or are identified with the same name, so that the description of these elements and of the functionality thereof as illustrated in the different embodiments are mutually exchangeable or may be applied to one another in the different embodiments.

### Detailed Description of the Figures

In the following description, embodiments are discussed in detail, however, it should be appreciated that the embodiments provide many applicable concepts that can be embodied in a wide variety of the field of laser devices. The specific embodiments discussed are merely illustrative of specific ways to implement and use the present concept, and do not limit the scope of the embodiments. In the following description of embodiments, the same or similar elements or elements that have the same functionality are provided with the same reference sign or are identified with the same name, and a repeated description of elements provided with the same reference number or being identified with the same name is typically omitted. In the following description, a plurality of details is set forth to provide a more thorough explanation of embodiments of the disclosure.

However, it will be apparent to one skilled in the art that other embodiments may be practiced without these specific details. In other instances, well-known structures and devices are shown in block diagram form rather than in detail in order to avoid obscuring examples described herein. In addition, features of the different embodiments described herein may be combined with each other, unless specifically noted otherwise.

It is understood that when an element is referred to as being "connected" or "coupled" to another element, it may be directly connected or coupled to the other element, or intermediate elements may be present. Conversely, when an element is referred to as being "directly" connected to another element, "connected" or "coupled," there are no intermediate elements. Other terms used to describe the relationship between elements should be construed in a similar fashion (e.g., "between" versus "directly between", "adjacent" versus "directly adjacent", and "on" versus "directly on", etc.).

For facilitating the description and the understanding of the different embodiments, the figures comprise a Cartesian coordinate system x, y, z, wherein the x-z-plane corresponds, i.e., is parallel, to a first main surface region of a substrate or an active layer of the laser device (= a reference plane = x-z-plane), wherein the direction vertically up with respect to the reference plane (x-z-plane) corresponds to the "+y" direction, and wherein the direction vertically down with respect to the reference plane (x-z-plane) corresponds to the "-y" direction. In the following description, the term "lateral" means a direction parallel to the x- and/or z-direction, i.e., parallel to or in the x-z-plane, wherein the term "vertical" means a direction parallel to the y-direction.

In the following description, a thickness of an element usually indicates a vertical dimension of such an element. In the figures, the different elements are not necessarily drawn to scale. Thus, the illustrated dimensions of the different elements may not be necessarily drawn to scale.

In the description of the embodiments, terms and text passages placed in brackets next to a described element or function are to be understood as further explanations, alternative designations, exemplary configurations, exemplary additions and/or exemplary alternatives of the described element or function.

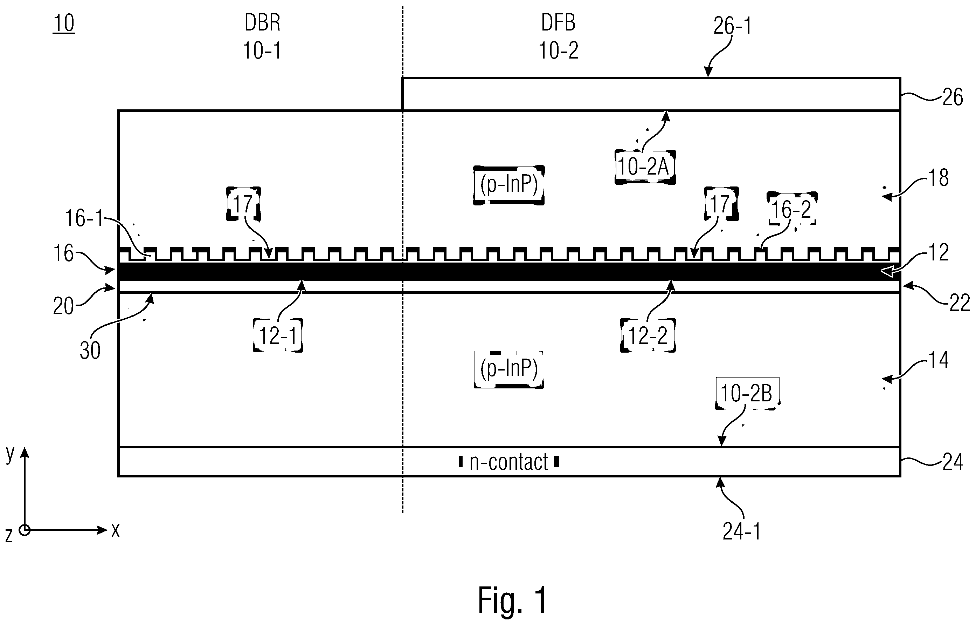

Fig. 1 shows a schematic cross-sectional view (parallel to the x-y plane) of a laser device 10 according to an embodiment of the present inventive concept.

As exemplarily shown in Fig. 1, the laser device 10 comprises an active layer structure 12 configured for generating laser light based on an injection current I_{IN} and arranged between a semiconductor substrate 14 and an integrally formed grating structure 16. The integrally formed grating structure 16 comprises a first grating section 16-1 and a second grating section 16-2 which are arranged laterally adjacent to each other. The first grating section 16-1 and the second grating section 16-2 of the integrally formed grating structure 16 commonly share the active layer structure 12 and have the same uniform grating period Λ. The first and second grating sections 16-1, 16-2 of the integrally formed grating structure 16 each comprise (or are formed as) an index coupling grating.

The first grating section 16-1 is arranged to have a first effective coupling coefficient κ₁ and the second grating section 16-2 is arranged to have a second effective coupling coefficient, κ₂, wherein the second effective coupling coefficient κ₂ is smaller than the first effective coupling coefficient κ₁. Further, a cladding structure 18 is arranged such that the integrally formed grating structure 16 is arranged between the active layer structure 12 and the cladding structure 18.

As further shown in Fig. 1, a first facet 20 and a second facet 22 are arranged at opposing end surfaces 12-1, 12-2 of the active layer structure 12, wherein the first facet 20 and the second facet 22 each comprise (or are formed as) an anti-reflection (AR) coating. Moreover, the laser device 10 comprises a contact structure 24, 26 arranged for providing (during an operating condition of the laser device) an injection current I_{IN} to the active layer structure 12 next to the second grating section 16-2.

According to an embodiment, the first and the second grating sections 16-1, 16-2 are arranged to have an uniform grating with the same uniform grating period for providing, during an operating condition of the laser device 10, a laser light L which is in the active layer structure 12 along the first and the second grating section 16-1, 16-2 in phase. The in-phase condition of the laser light L, which propagates along the active layer structure 12 and the first and the second grating sections 16-1, 16-2 is a result of the (above indicated) "uniform" structure and arrangement of the first and second grating sections 16-1, 16-2 of the integrally formed grating structure 16 in form of an index coupling grating. The term index coupling grating or index grating generally refer to gratings where the refractive index of the material changes periodically, causing light to be diffracted. Thus, an index-coupled DFB laser (DFB = Distributed Feedback) is a type of laser diode in which the optical feedback process takes place through index modulation, i.e. changes in the refractive index.

According to the inventive arrangement of the DFB-DBR laser device 10, the integrally formed grating structure 16 comprises the first grating section 16-1 (DBR grating) and the second grating section 16-2 (DFB grating), wherein the index coupled DBR grating 16-1 and DFB grating 16-2 share the same active layer 12. Both facets 20, 22 (at opposing ends 12-1, 12-2 of the active layer 12) are AR-coated (AR = anti-reflection).

According to an embodiment, the DBR grating 16-1 has a first (relatively high) coupling coefficient whereas the DFB grating 16-2 has a second lower coupling coefficient. Furthermore, the DFB grating 16-2 does not have implemented a quarter lambda (λ/4) phase shift, i.e. an uniform grating (e.g. uniform grating period) is used for the DBR grating 16-1 and the DFB grating 16-2.

According to an embodiment, the first grating section 16-1 may be arranged to have a first effective coupling coefficient κ₁ which is between 150 and 300 cm⁻¹. According to an embodiment, the first grating section 16-1 and the second grating section 16-2 of the integrally formed grating structure 16 may be arranged such that the second effective coupling coefficient κ₂ is at least 20 % smaller, e.g. between 20 and 60 % smaller, than the first effective coupling coefficient κ₁.

According to embodiments of the present disclosure, at least one (A, B or C) or any combination (A+B / A+C / B+C / A+B+C) of the following configurations A, B, C can be used for providing the smaller second effective coupling coefficient κ₂ of the second grating section 16-2 than the first effective coupling coefficient κ₁ of the first grating section 16-1.

According to an embodiment, (A) the second grating section 16-2 of the integrally formed grating structure 16 may be arranged to have a reduced number of teeth 17 when compared to first grating section 16-1 of the integrally formed grating structure 16. (B) The second grating section 16-2 may be arranged to have a reduced (lateral) grating width w_{DFB} when compared to first grating section 16-1. (C) The second grating section 16-2 may be arranged to have a reduced grating depth d_{DFB} when compared to first grating section 16-1. Etc.

According to an embodiment, the laser device 10 may be arranged to comprise a reflection section (DBR part) 10-1 having the first grating section 16-1 for providing a DBR reflection functionality (DBR = distributed bragg reflection) of the laser device 10 for the generated laser light L. Further, the laser device 10 may be arranged to comprise an active section (DFB part) 10-2 having the second grating section 16-2 for providing a DFB transmission functionality (DFB = distributed feedback) of the laser device 10 for the generated laser light L propagating along the active layer structure 12 with the integrally formed grating structure 16.

According to an embodiment, the active section 10-2 of the laser device 10 with the second grating section 16-2 is arranged to provide a transmission spectrum for the generated laser light that is shifted to longer wavelengths when compared to the reflection spectrum of the reflection section 10-1 of the laser device 10 with the first grating section 16-1.

The DBR section 10-1 may comprise a lateral extension (length parallel to the x direction) with a value between 50 and 150 µm or between 80 and 120 µm or about 100 µm (± 10%) and an index grating coupling coefficient with a value between 150 and 300 cm⁻¹ or about 200 cm⁻¹ (± 10%). Based on a length of 100 µm and an index grating coupling coefficient of 200 cm⁻¹, the DBR section 10-1 may provide about 93% reflection. The DFB section 10-2 may have a length with a value between 100 and 400 µm or between 250 and 350 µm or about 300 µm (± 10%) and the same (uniform) index grating as the DBR section 10-1.

To realize the laser DBR and DFB gratings 16-1, 16-2 of the laser device 10, the integrally formed grating structure 16 with the first and second grating sections 16-1, 16-2 may be defined within one e-beam (electron beam) grating field so that they are in phase, i.e. without any phase shift in between. An e-beam grating field refers to a specific area on a substrate where an electron beam lithography (EBL) system writes a grating pattern. EBL is a technique used to create precise nanoscale patterns, and in this context, a "grating field" is the defined area where a repeating, periodic structure (the integrally formed grating structure 16) is being written.

As exemplarily shown in Fig. 1, the laser device 10 comprises the contact structure 24, 26 arranged for providing (during an operating condition of the laser device) an injection current I_{IN} to the active layer structure 12 next to the second grating section 16-2, i.e. to the part 12-2 of the active layer structure 12 in the DFB part 10-2 of the laser device 10. According to an embodiment, the contact structure 24, 26 may comprise the contact regions 24-1, 26-1 which are arranged on opposing main surface regions 10-2A, 10-2B of the active section 10-2 of the laser device 10.

According to an embodiment, the cladding structure 18 may comprise a semiconductor material, wherein a conductivity type of the semiconductor substrate 14 is opposite to a conductivity type of the semiconductor material of the cladding structure. For example, the conductivity type of the semiconductor substrate 14 may comprises n-type and the conductivity type of the cladding structure 18 may comprises p-type, or vice versa. The material of the cladding layer 18 may comprise at least one of a quaternary layer, InGaAs and InP cladding. According to an embodiment, whilst not excluding other suitable materials, the semiconductor substrate 14 may comprise at least one of InP, GaAs, Si, SiC, SiNx and thin film lithium niobate.

According to an embodiment, the active layer structure 12 may comprises at least one of an InGaAsP (QW)/ InGaAsP (barrier) multi-quantum well, MQW, an InGaAlAs (QW)/ InGaAlAs (barrier) MQW, an InGaAsP (QW) /InGaAlAs (barrier) MQW, InAs multi-quantum dot, MQD and an InAs MQDash material. The active layer structure 12 may comprise a common active layer configured for a generation of laser light having at least one of these materials. Moreover, the active layer structure 12 may comprise or may be formed as a layer stack, structured comprising a certain multiple quantum well (MQW) structure and/or sandwiched between certain waveguide layers.

As exemplarily shown in Fig. 1, the laser device 10 may further (optionally) comprise a buffer layer 30 (e.g. a N-dielectric material layer) for an optical confinement of the laser radiation (laser light) L light generated in and propagating along the active layer structure 12

According to an embodiment, the laser device may further comprise at least one semiconductor optical amplifier, SOA, section arranged on the active layer structure between the second grating structure 16-2 and the corresponding facet 22. The SOA may be configured to increase an output power of the laser light.

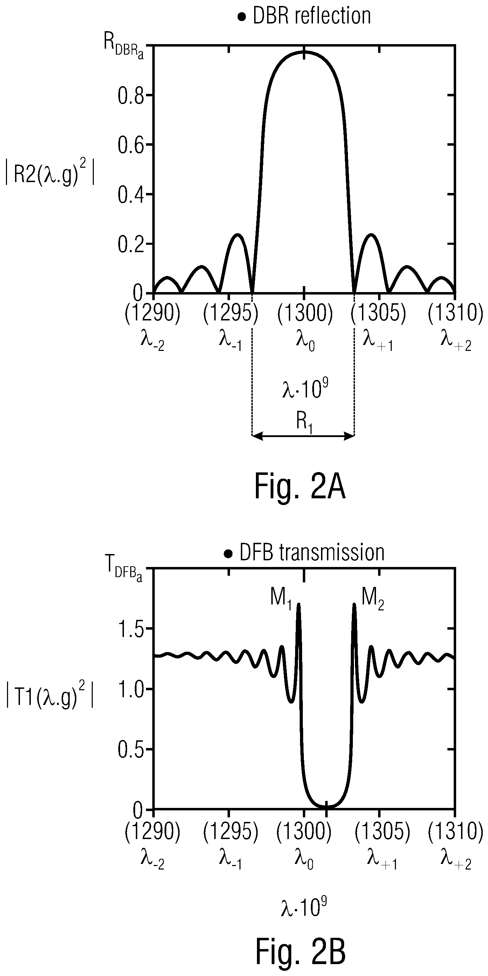

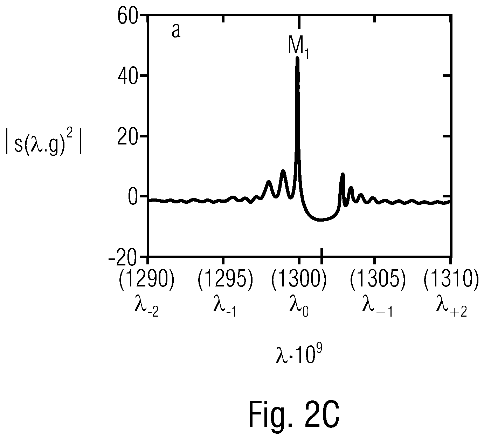

The mode selection mechanism of the inventive laser device 10 of Fig. 1 is now described with respect to Figs. 2a-c. Fig. 2a shows a (e.g. simulated) DBR reflection spectrum based on the reflection section 10-1 of the laser device 10, Fig. 2b shows the corresponding (e.g. simulated) DFB transmission spectrum based on the active section 10-2 of the laser device 10, and Fig. 2c shows the resulting (e.g. simulated) stable single mode operation spectrum of the laser device 10 according to an embodiment of the present inventive concept.

The mode selection mechanism of the laser device 10 works as follows: The (simulated) DBR reflection spectrum R_{DBR} of the laser device 10 of Fig. 2a is shown to have a center wavelength λ₀ and is shown between λ₋₂ (= λ₀ - 2 Δλ) and λ₊₂ (= λ₀ + 2 Δλ) with the wavelength interval Δλ (e.g. Δλ = λ₂ - λ₁ = λ₁ - λ₀ = λ₀ - λ-₁ = λ₋₁ - λ₋₂ etc. ). The resulting center wavelength λ₀ of the laser device 10 may have a value between 1200 and 1800 nm or may be (about) 1300 nm or 1550 nm etc. for laser devices 10 on an InP substrate 14, for example, wherein the exemplary wavelength interval Δλ may be 1, 5 or 10 nm (or any other suitable value).

The (simulated) DFB transmission spectrum T_{DFB} of the laser device 10 of Fig. 2b is shown to have a shifted center wavelength λ'₀ and is shown between λ₋₂ and λ₊₂ with the wavelength interval Δλ. The DFB part 10-2 of the laser device 10 comprises the second grating section 16-2 with a reduced coupling coefficient compared with the first grating section 16-1 of the DBR part 10-1 of the laser device 10. Due to the reduced coupling coefficient in the DFB part 10-2 of the laser device 10, the effective refractive index of the DFB part 10-2 is higher than in the DBR part 10-1. The corresponding DFB transmission spectrum T_{DFB} and, thus, its center wavelength λ'₀ is therefore shifted to longer wavelengths when compared to the DBR reflection spectrum R_{DBR} of the laser device 10. The DFB transmission spectrum T_{DFB} have the (main) DFB modes M₁, M₂. Consequently, the DBR part 10-1 now acts as a reflector only for the left DFB mode M₁ of the DFB part 10-2, wherein the combination of the (shifted) DFB transmission spectrum T_{DFB} and the DBR reflection spectrum R_{DBR} result in a stable single mode operation of the laser device 10 as depicted in Fig. 2c. The right DFB mode M₂ is shifted out of the main reflection region R₁ if the DBR reflection spectrum R_{DBR} of the DBR part 10-1.

As the first grating section 16-1 and the second grating section 16-2 of the integrally formed grating structure 16 commonly share the active layer structure 12 and have the same uniform grating (the same uniform grating period Λ), the laser light L is "in phase" and propagates in the active layer structure 12 along the first and the second grating section 16-1, 16-2 during an operating condition of the laser device 10. Due to the uniform grating of the integrally formed grating structure 16, there is no phase shift of the propagating laser light L along the active layer structure 12 in the first and the second grating section 16-1, 16-2 and in between the first and the second grating section 16-1, 16-2.

Thus, the described inventive implementation of the laser device 10 results in an improved DBR-DFB-laser configuration for a laser device by using a new (specific) mode selection mechanism based on the higher (first) coupling coefficient κ₁ of the DBR grating 16-1 when compared to the second (lower) coupling coefficient κ₂ of the DFB grating 16-2. The improved DBR-DFB-laser configuration for the laser device 10 results in a close to 100% single mode yield and also prevents any spatial hole burning by using the new (specific) mode selection mechanism.

Further, the laser device 10 having the specific DBR-DFB-laser configuration enables to significantly improve the single mode yield of the AR/HR facet coated index coupled DFB laser devices and EMLs (EMLs = Electro-absorption modulated lasers).

The described DBR-DFB-laser design of the laser device 10 results in:
- high single mode yield for DFB lasers with high reflective back facet 20, 22, here realized with a DBR part 10-1;
- as there is no quarter lambda (λ/4) shift used in the DFB part 10-2 any spatial hole burning effects are prevented;
- compared with AR/HR coated DFBs, the optical intensity at the back facet 20 is very low so any COD (COD = coefficient of dispersion) in case of DFB lasers with InGaAlAs based active layers is avoided here.

Before describing further embodiments, it should be noted that in the present description of embodiments, same or similar elements having the same structure and/or function are provided with the same reference numbers or the same name, wherein a detailed description of such elements will not be repeated for every embodiment. Thus, the above description of the laser device 10 with respect to Figs. 1 and 2a-c is equally applicable to the further embodiments as described below. In the following description, different implementations of the embodiments of the laser device 10 of Figs. 1 and, essentially, the differences, e.g. additional elements and/or structures, and the technical effect(s) resulting therefrom are discussed in detail.

The following description now shows schematic (cross sectional and plane) views of different and alternative implementations of the laser device 10 in accordance with further embodiments of the present disclosure.

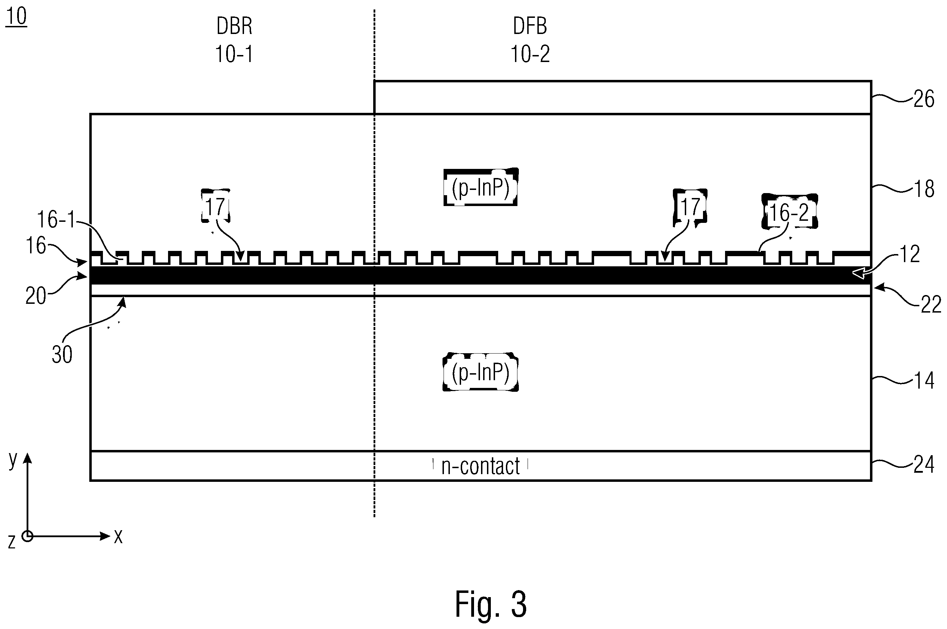

Fig. 3 shows a schematic cross-sectional view (parallel to the x-y plane) of the laser device 10 according to a further embodiment of the present inventive concept. As exemplarily shown in Fig. 3, the laser device 10 is arranged as described with respect to Figs. 1 and 2a-c, wherein the second grating section 16-2 of the integrally formed grating structure 16 is arranged to have a reduced number of teeth 17 when compared to first grating section 16-1 of the integrally formed grating structure 16. Thus, the second effective coupling coefficient κ₂ of the second grating section 16-2 may be set to be smaller, e.g. at least 20 % smaller, than the first effective coupling coefficient κ₁ of the first grating section 16-1 of the integrally formed grating structure 16.

The DBR section 10-1 may comprise a lateral extension (length parallel to the x direction) with a value between 50 and 150 µm or between 80 and 120 µm or about 100 µm (± 10%) and an index grating coupling coefficient with a value between 150 and 300 cm⁻¹ or about 200 cm⁻¹ (± 10%). Based on a length of 100 µm and an index grating coupling coefficient of 200 cm⁻¹, the DBR section 10-1 may provide about 93% reflection. The DFB section 10-2 may have a length with a value between 100 and 400 µm or between 250 and 350 µm or about 300 µm (± 10%) and the same index grating (with the same etched grating depth and/or width) as the DBR section 10-1.

As exemplarily shown in Fig. 3, the second grating section 16-2 (DFB part 10-2) of the integrally formed grating structure 16 has a configuration where 1-out-of-4 grating teeth 17 is not etched. However, further optional configuration could be e.g. where 4-out-of-8, 3-out-of-7, ... , grating teeth 17 are not etched. Alternatively, also grating teeth 17 could be irregularly removed without following a certain pattern.

Effectively, the removal (omitting) of grating teeth 17 in the second grating section 16-2 (DFB part 10-2) of the integrally formed grating structure 16 has two consequences:
a) The effective coupling coefficient κ₂ in the DFB part 10-2 is reduced (compared with the DBR part 10-1) which is needed for lasing (for providing a lasing condition);
b) The refractive index in the DFB part 10-2 is higher than in the DBR part 10-1 resulting in a long-wavelength shift of the respective spectrum resulting in single mode operation as explained above.

To realize the laser DBR and DFB gratings 16-1, 16-2 of the laser device 10, the integrally formed grating structure 16 with the first and second grating sections 16-1, 16-2 may be defined within one e-beam (electron beam) grating field so that they are in phase, i.e. without any phase shift in between. Consequently, there is only one step for the grating definition and etch processing required to realize the laser device 10.

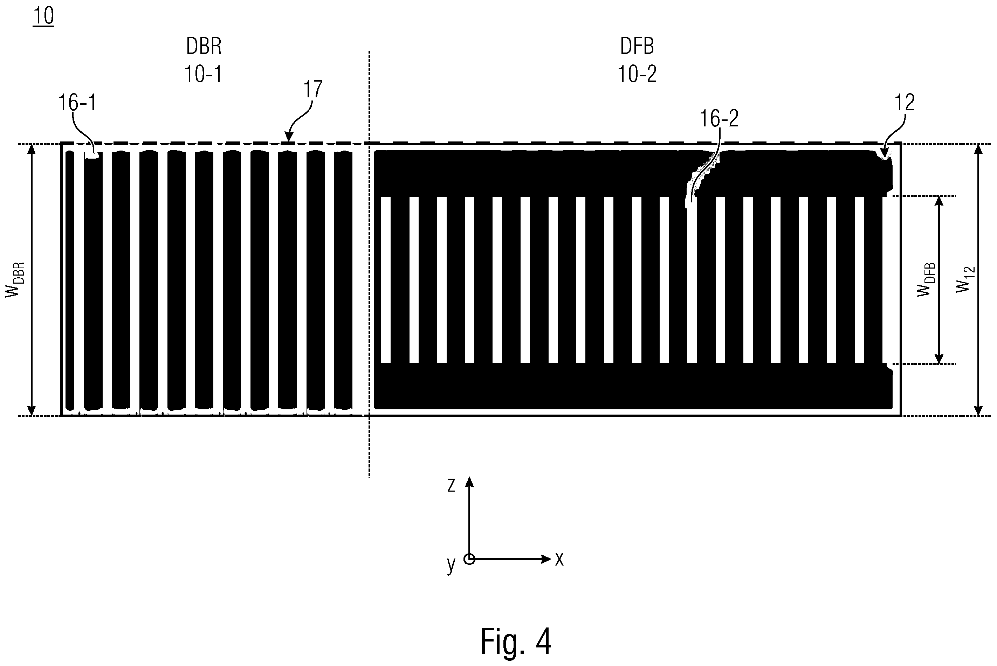

Fig. 4 shows a schematic cross-sectional view (parallel to the x-z plane) of the laser device 10 according to a further embodiment of the present inventive concept. As exemplarily shown in Fig. 4, the laser device 10 is again arranged as described with respect to Figs. 1 and 2a-c, wherein the second grating section 16-2 is arranged to have a reduced (lateral) DFB grating width w_{DFB} when compared to the DBR grating width w_{DBR} of first grating section 16-1 of the integrally formed grating structure 16. Thus, the second effective coupling coefficient κ₂ of the second grating section 16-2 may be set to be smaller, e.g. at least 20 % smaller, than the first effective coupling coefficient κ₁ of the first grating section 16-1 of the integrally formed grating structure 16.

As exemplarily shown in Fig. 4, the laser device 10 has in the DBR part 10-1 and the DFB part 10-2 an identical grating 16 (same depth, no teeth removed), however in the DFB part 10-2 the width w_{DFB} of the etched grating 16-2 (z-direction) is reduced compared with the laser stripe width w₁₂ and/or the DBR grating width w_{DBR} of first grating section 16-1. The laser stripe width w₁₂ is the (lateral) width (z direction) of the active layer structure 12. In Fig. 4, a sharp interface (width change) may be arranged between the width w_{DBR} and w_{DFB} of two grating sections 16-1, 16-2. As long as the grating sections 16-1, 16-2 are in phase (without any phase shift in between), a gradual transition (along some grating teeth 17) between the width w_{DBR} and w_{DFB} of the grating sections 16-1, 16-2 is also possible.

Thus, the DFB grating width w_{DFB} of the second grating section 16-2 may be set to be smaller, e.g. between 20 and 60 % smaller, than the DBR grating width w_{DBR} of the first grating section 16-1 of the integrally formed grating structure 16.

Effectively, the reduced width w_{DFB} of the second grating section 16-2 (DFB part 10-2) of the integrally formed grating structure 16 has also the two consequences:
a) The effective coupling coefficient κ₂ in the DFB part 10-2 is reduced (compared with the DBR part 10-1) which is needed for lasing (for providing a lasing condition);
b) The refractive index in the DFB part 10-2 is higher than in the DBR part 10-1 resulting in a long-wavelength shift of the respective spectrum resulting in single mode operation as explained above.

To realize the laser DBR and DFB gratings 16-1, 16-2 of the laser device 10, the integrally formed grating structure 16 with the first and second grating sections 16-1, 16-2 may be defined within one e-beam (electron beam) grating field so that they are in phase, i.e. without any phase shift in between. Consequently, there is only one step for the grating definition and etch processing required to realize the laser device 10.

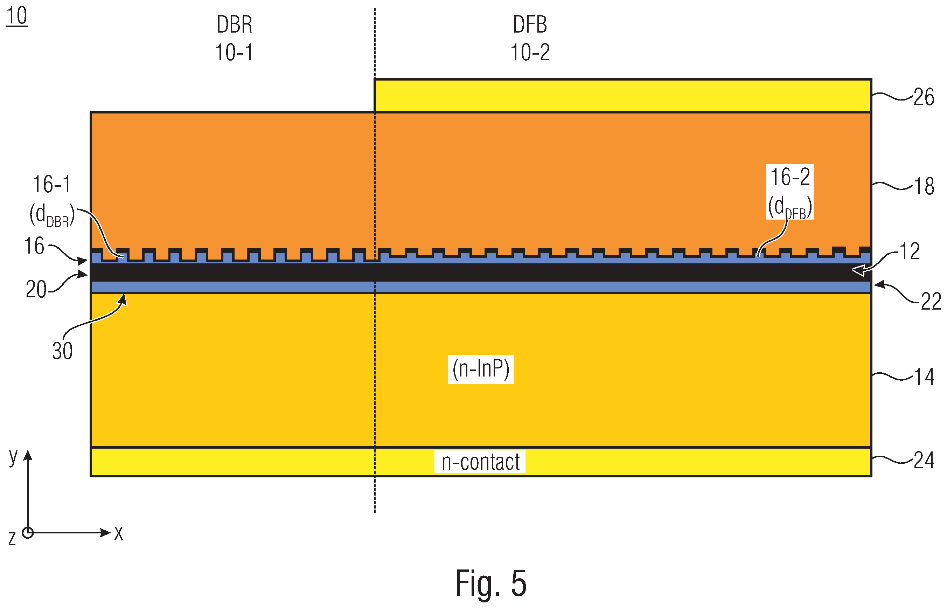

Fig. 5 shows a schematic cross-sectional view (x-y plane) of the laser device 10 according to a further embodiment of the present inventive concept. As exemplarily shown in Fig. 3, the laser device 10 is arranged as described with respect to Figs. 1 and 2a-c, wherein the second grating section 16-2 of the integrally formed grating structure 16 may be arranged to have a reduced DFB grating depth d_{DFB} when compared to the DBR grating depth d_{DBR} of the first grating section 16-1. Thus, the second effective coupling coefficient κ₂ of the second grating section 16-2 may be set to be smaller, e.g. at least 20 % smaller, than the first effective coupling coefficient κ₁ of the first grating section 16-1 of the integrally formed grating structure 16.

Thus, the DFB grating depth d_{DFB} of the second grating section 16-2 may be set to be smaller, e.g. between 20 and 60 % smaller, than the DBR grating depth d_{DBR} of the first grating section 16-1 of the integrally formed grating structure 16.

Instead of a removal of grating teeth in the DFB part (see Fig. 3), the coupling coefficient in the DFB part 10-2 can be reduced by etching a shallower grating 16-2 (smaller grating depth d_{DFB}) when compared to the first grating 16-1.

To realize the laser DBR and DFB gratings 16-1, 16-2 of the laser device 10, the integrally formed grating structure 16 with the first and second grating sections 16-1, 16-2 may be defined within one e-beam (electron beam) grating field so that they are in phase, i.e. without any phase shift in between. In this variant of Fig. 5, two different grating etching processing steps may be required with a sharp interface between the two grating sections 16-1, 16-2 in order to avoid any unwanted additional phase shift in between.

Effectively, the reduced depth d_{DFB} of the second grating section 16-2 (DFB part 10-2) of the integrally formed grating structure 16 has also the two consequences:
a) The effective coupling coefficient κ₂ in the DFB part 10-2 is reduced (compared with the DBR part 10-1) which is needed for lasing (for providing a lasing condition);
b) The refractive index in the DFB part 10-2 is higher than in the DBR part 10-1 resulting in a long-wavelength shift of the respective spectrum resulting in single mode operation as explained above.

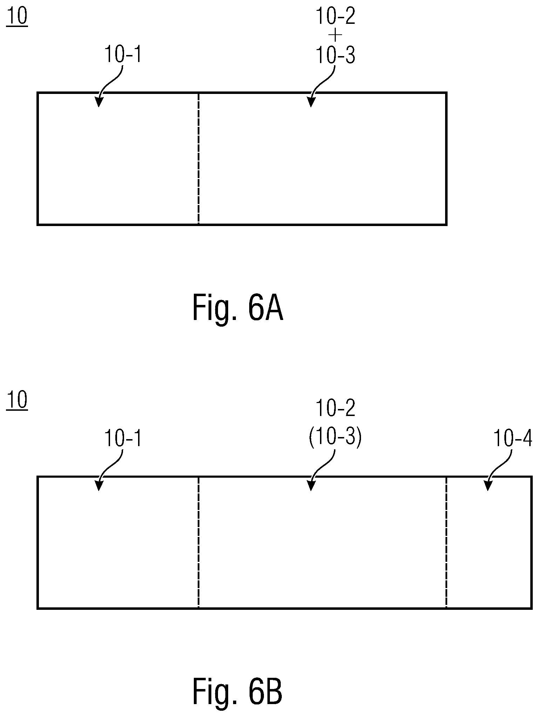

Fig. 6a-b show schematic block diagrams of a laser arrangement 50 having the laser device 10 according to an embodiment of the present inventive concept.

As exemplarily and schematically shown in Fig. 6a, the laser arrangement 50 comprises the laser device 10, as described above with respect to Figs. 1, 2a-c, 3, 4 and 5, wherein the laser device 10 is monolithically integrated with at least one further passive and/or active optical component 10-3. Such an optical component may comprise at least one of an electro-absorption modulator (EAM), a semiconductor optical amplifier (SOA), an electro-absorption modulator and a semiconductor optical amplifier (SOA), a Mach-Zehnder modulator (MZM), or a photonic integrated circuit. Monolithically integrated refers to a system where multiple components or functions are combined into a single, unified structure, typically on the same substrate or chip.

As exemplarily and schematically shown in Fig. 6a, the laser arrangement 50 comprises the laser device 10, as described above with respect to Figs. 1,2a-c, 3, 4 and 5, wherein the laser device 10 is hybridly integrated with a photonic integrated circuit 10-4. An hybrid integration can combine multiple material platforms via optical coupling. An hybrid/heterogeneous integration of active and passive components in different material systems may be used multifunctional photonic integrated circuits. In addition, many other optical components such as modulators, isolators, amplifiers, and detectors can be co-integrated on the same chip (substrate) for a wide range of communication, computing, sensing, and signal processing applications.

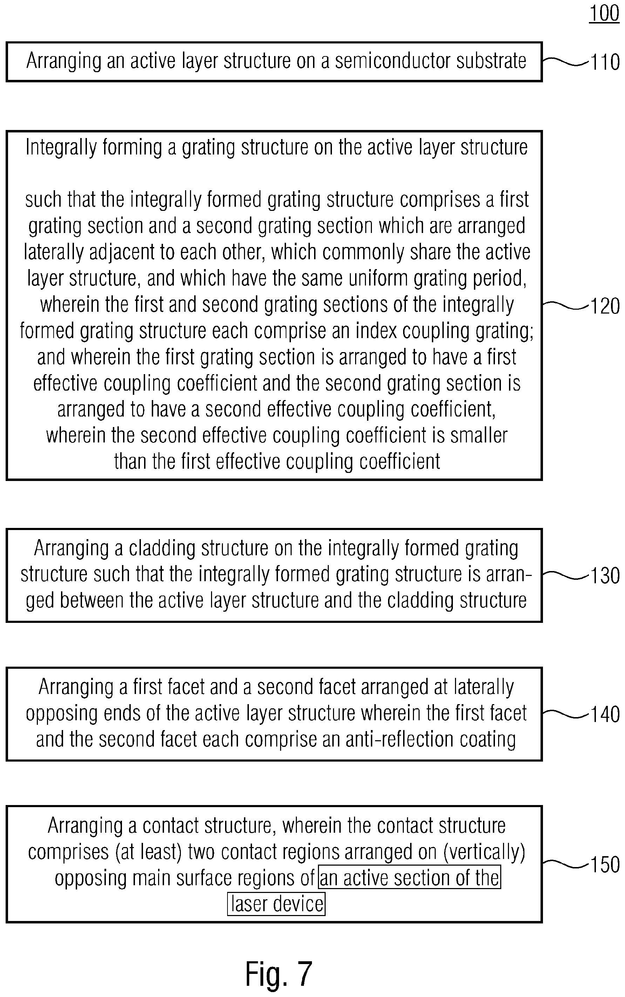

Fig. 7 shows a schematic block diagram of a method 100 for manufacturing a laser device 10 according to an embodiment of the present inventive concept.

According to an embodiment, the method 100 for manufacturing the laser device 10 comprises the steps of arranging 110 an active layer structure on a semiconductor substrate, integrally forming 120 a grating structure on the active layer structure such that the integrally formed grating structure comprises a first grating section and a second grating section which are arranged laterally adjacent to each other, which commonly share the active layer structure, and which have the same uniform grating period, wherein the first and second grating sections of the integrally formed grating structure each comprise an index coupling grating; and wherein the first grating section is arranged to have a first effective coupling coefficient and the second grating section is arranged to have a second effective coupling coefficient, wherein the second effective coupling coefficient is smaller than the first effective coupling coefficient; arranging 130 a cladding structure on the integrally formed grating structure such that the integrally formed grating structure is arranged between the active layer structure and the cladding structure; arranging 140 a first facet and a second facet arranged at laterally opposing ends of the active layer structure wherein the first facet and the second facet each comprise an anti-reflection coating; and arranging 150 a contact structure, wherein the contact structure comprises (at least) two contact regions arranged on (vertically) opposing main surface regions of an active section of the laser device.

According to an embodiment, the method 100 may further comprise the step of forming 160 the first and the second grating section to have the same uniform grating period for providing, during an operating condition of the laser device, a laser light which is in the active layer structure along the first and the second grating section in phase.

According to an embodiment, the method 100 may be conducted so that the integrally formed grating structure may be obtained by a common or single electron beam writing process. According to an embodiment, the method 100 may be conducted so that the integrally formed grating structure is defined within a single electron beam (Ebeam) grating field.

To realize the laser DBR and DFB gratings 16-1, 16-2 of the laser device 10, the integrally formed grating structure 16 with the first and second grating sections 16-1, 16-2 may be defined within one e-beam (electron beam) grating field so that they are in phase, i.e. without any phase shift in between. An e-beam grating field refers to a specific area on a substrate where an electron beam lithography (EBL) system writes a grating pattern. EBL is a technique used to create precise nanoscale patterns, and in this context, a "grating field" is the defined area where a repeating, periodic structure (the integrally formed grating structure 16) is being written. Consequently, there is only one step for the grating definition and (optionally) for the etch processing required to realize the laser device 10.

According to an embodiment, a laser device comprises an active layer structure configured for generating laser light based on an injection current and arranged between a semiconductor substrate and an integrally formed grating structure, wherein the integrally formed grating structure comprises a first grating section and a second grating section which are arranged laterally adjacent to each other, which commonly share the active layer structure, and which have the same uniform grating period; wherein the first and second grating sections of the integrally formed grating structure each comprise an index coupling grating; and wherein the first grating section is arranged to have a first effective coupling coefficient and the second grating section is arranged to have a second effective coupling coefficient, wherein the second effective coupling coefficient is smaller than the first effective coupling coefficient; a cladding structure arranged such that the integrally formed grating structure is arranged between the active layer structure and the cladding structure; a first facet and a second facet, which are arranged at opposing end surfaces of the active layer structure, wherein the first facet and the second facet each comprise an anti-reflection (AR) coating; and a contact structure arranged for providing the injection current to the active layer structure next to the second grating section.

According to an embodiment, the first and the second grating section may be arranged to have the same uniform grating period for providing, during an operating condition of the laser device, a laser light which is in the active layer structure along the first and the second grating section in phase.

According to an embodiment, the first grating section may be arranged to have a first effective coupling coefficient which is between 150 and 300 cm⁻¹.

According to an embodiment, the first grating section and the second grating section may be arranged such that the second effective coupling coefficient is at least 20 % smaller than the first effective coupling coefficient.

According to an embodiment, the second grating section may be arranged to have a reduced number of teeth when compared to first grating section.

According to an embodiment, the second grating section may be arranged to have a reduced grating width when compared to first grating section.

According to an embodiment, the second grating section may be arranged to have a reduced grating depth when compared to the first grating section.

According to an embodiment, the laser device may be arranged to comprise a reflection section having the first grating section for providing a DBR reflection functionality (DBR = distributed bragg reflection) of the laser device for the generated laser light.

According to an embodiment, the laser device may be arranged to comprise the active section having the second grating section for providing a DFB transmission functionality (DFB = distributed feedback) of the laser device for the generated laser light.

According to an embodiment, the active section with the second grating section may be arranged to provide a transmission spectrum for the generated laser light that is shifted to longer wavelengths when compared to the reflection spectrum of the reflection section with the first grating section.

According to an embodiment, the contact structure may comprise contact regions arranged on opposing main surface regions of the active section.

According to an embodiment, the cladding structure may comprise a semiconductor material, wherein a conductivity type of the semiconductor substrate is opposite to a conductivity type of the semiconductor material of the cladding structure.

According to an embodiment, the semiconductor substrate may comprise at least one of InP, GaAs, Si, SiC, SiNx and thin film lithium niobate.

According to an embodiment, the active layer structure may comprise at least one of an InGaAsP (QW)/ InGaAsP (barrier) multi-quantum well, MQW, an InGaAlAs (QW)/ InGaAlAs (barrier) MQW, an InGaAsP (QW) /InGaAlAs (barrier) MQW, InAs multi-quantum dot, MQD and an InAs MQDash material.

According to an embodiment, the laser device may further comprise at least one semiconductor optical amplifier, SOA, section arranged on the active layer structure between the second grating structure and the corresponding facet, the SOA configured to increase an output power of the laser light.

According to an embodiment, a laser arrangement may comprise the laser device, wherein the laser device is monolithically integrated with at least one of: an electro-absorption modulator (EAM), a semiconductor optical amplifier (SOA), an electro-absorption modulator and a semiconductor optical amplifier (SOA), a Mach-Zehnder modulator (MZM), or a photonic integrated circuit.

According to an embodiment, a laser arrangement may comprise the laser device, wherein the the laser device is hybridly integrated with a photonic integrated circuit.

According to an embodiment, a method for manufacturing a laser device may comprise arranging an active layer structure on a semiconductor substrate; integrally forming a grating structure on the active layer structure such that the integrally formed grating structure comprises a first grating section and a second grating section which are arranged laterally adjacent to each other, which commonly share the active layer structure, and which have the same uniform grating period, wherein the first and second grating sections of the integrally formed grating structure each comprise an index coupling grating; and wherein the first grating section is arranged to have a first effective coupling coefficient and the second grating section is arranged to have a second effective coupling coefficient, wherein the second effective coupling coefficient is smaller than the first effective coupling coefficient; arranging a cladding structure on the integrally formed grating structure such that the integrally formed grating structure is arranged between the active layer structure and the cladding structure; arranging a first facet and a second facet arranged at laterally opposing ends of the active layer structure wherein the first facet and the second facet each comprise an anti-reflection coating; and arranging a contact structure, wherein the contact structure comprises (at least) two contact regions arranged on (vertically) opposing main surface regions of an active section of the laser device.

According to an embodiment, the method may further comprise the step of forming the first and the second grating section to have the same uniform grating period for providing, during an operating condition of the laser device, a laser light which is in the active layer structure along the first and the second grating section in phase.

According to an embodiment, the integrally formed grating structure may be obtained by a common or single electron beam writing process.

According to an embodiment, the integrally formed grating structure may be defined within a single electron beam (Ebeam) grating field.

Although some aspects have been described as features in the context of an apparatus, it is clear that such a description may also be regarded as a description of corresponding features of a method. Although some aspects have been described as features in the context of a method, it is clear that such a description may also be regarded as a description of corresponding features concerning the functionality of an apparatus.

Depending on certain implementation requirements, embodiments of a control circuitry can be implemented in hardware or in software or at least partially in hardware or at least partially in software. Generally, embodiments of the control circuitry can be implemented as a computer program product with a program code, the program code being operative for performing one of the methods when the computer program product runs on a computer. The program code may, for example, be stored on a machine-readable carrier.

In the foregoing detailed description, it can be seen that various features are grouped together in examples for the purpose of streamlining the disclosure. This method of disclosure is not to be interpreted as reflecting an intention that the claimed examples require more features than are expressly recited in each claim. Rather, as the following claims reflect, subject matter may lie in less than all features of a single disclosed example. Thus, the following claims are hereby incorporated into the detailed description, where each claim may stand on its own as a separate example. While each claim may stand on its own as a separate example, it is to be noted that, although a dependent claim may refer in the claims to a specific combination with one or more other claims, other examples may also include a combination of the dependent claim with the subject matter of each other dependent claim or a combination of each feature with other dependent or independent claims. Such combinations are proposed herein unless it is stated that a specific combination is not intended. Furthermore, it is intended to include also features of a claim to any other independent claim even if this claim is not directly made dependent to the independent claim.

Although specific embodiments have been illustrated and described herein, it will be appreciated by those of ordinary skill in the art that a variety of alternate and/or equivalent implementations may be substituted for the specific embodiments shown and described without departing from the scope of the present embodiments. This application is intended to cover any adaptations or variations of the specific embodiments discussed herein. Therefore, it is intended that the embodiments be limited only by the claims and the equivalents thereof.

### References

[1.1] B.B. Buckley, T. M. Fryslie, K. Guinn, G. Morrison, A. Gazman, Y. Shen , K. Bergman, M. L. Mashanovitch, "WDM Source Based on High-Power, Efficient 1280-nm DFB Lasers for Terabit Interconnect Technologies", IEEE Photon. Techn. Lett., vol. 30, no. 22, November 15, 2018, pp1929...1932
[1.2] R. Hatai, K. Nakahara, A. Nakamura, T. Nakajima, Y. Kobayashi, T. Kageyama and S. Tanaka, "CW-WDM MSA compatible 100-mW (up to 50°C), 400-GHz spacing highly-reliable CW-DFB 8-channel laser array", Optical Fiber Conference 2024, San Diego, paper M1D.1
[1.3] S. Sulikhah, K. A. Malicsi Dela Cruz, S.-L. Lee, C.-G. Tu, I.-F Jang, H.-P. Shiao, C. H. Wu, and H.-C. Yen, "Multi-Section Partially-Corrugated-Grating DFB Lasers for Achieving High Power, Low Noise, and Narrow Linewidth", Opticle Fiber Converence 2024, San Diego, paper W2A.18 [1.4] US20250079794A1
[1.5] Y. Zhang , Z. Sun , J. Zhao , Z. Wang , Z. Li, R. Xiao , W. Wang, Z. Yang, K. Tang , W. Sun, L. Wang , K. Xu , Z Xu , Y. Ma, J. Lu, and X. Chen," Over 100 mW O-Band Multi-Wavelength DFB Laser Array for Optical I/O Technology" IEEE Photon. Techn. Lett., vol. 36, no. 13, 1 July 2024, pp821...824
[1.6] US7873089
[1.7] G.ONGHAI LIU, G. O. Zhao , J. U. S UN , D. G. AO ,Q. I. Lu , A. W. E. G. Uo, "Experimental demonstration of DFB lasers with active distributed reflector", Optics Express, vol 26, no, 23, 12 Nov 2018, pp29784-29795

## Claims

1. A laser device (10), comprising:
an active layer structure (12) configured for generating laser light based on an injection current (I_{IN}) and arranged between a semiconductor substrate (14) and an integrally formed grating structure (16),
wherein the integrally formed grating structure (16) comprises a first grating section (16-1) and a second grating section (16-2) which are arranged laterally adjacent to each other, which commonly share the active layer structure (12), and which have the same uniform grating period;
wherein the first and second grating sections (16-1, 16-2) of the integrally formed grating structure (16) each comprise an index coupling grating; and wherein the first grating section (16-1) is arranged to have a first effective coupling coefficient and the second grating section (16-2) is arranged to have a second effective coupling coefficient, wherein the second effective coupling coefficient is smaller than the first effective coupling coefficient;
a cladding structure (18) arranged such that the integrally formed grating structure (16) is arranged between the active layer structure (12) and the cladding structure (18);
a first facet (20) and a second facet (22), which are arranged at opposing end surfaces of the active layer structure (12), wherein the first facet (20) and the second facet (22) each comprise an anti-reflection (AR) coating; and
a contact structure (24, 26) arranged for providing the injection current (I_{IN}) to the active layer structure (12) next to the second grating section (16-2).

2. The laser device (10) of claim 1, wherein the first and the second grating section (16-1, 16-2) are arranged to have the same uniform grating period for providing, during an operating condition of the laser device (10), a laser light (L) which is in the active layer structure (12) along the first and the second grating section (16-1, 16-2) in phase.

3. The laser device (10) of claim 1 or 2, wherein the first grating section (16-1) is arranged to have a first effective coupling coefficient which is between 150 and 300 cm⁻¹.

4. The laser device (10) of any of the preceding claims, wherein the first grating section (16-1) and the second grating section (16-2) are arranged such that the second effective coupling coefficient is at least 20 % smaller than the first effective coupling coefficient.

5. The laser device (10) of any of the preceding claims, wherein the second grating section (16-2) is arranged to have a reduced number of teeth (17) when compared to first grating section.

6. The laser device of any of the preceding claims,
wherein the second grating section (16-2) is arranged to have a reduced grating width when compared to the first grating section (16-1),
and/or
wherein the second grating section (16-2) is arranged to have a reduced grating depth when compared to the first grating section (16-2).

7. The laser device (10) of any of the preceding claims,
wherein the laser device (10) is arranged to comprise a reflection section (10-1) having the first grating section (16-1) for providing a DBR reflection functionality (DBR = distributed bragg reflection) of the laser device (10) for the generated laser light (L), and/or
wherein the laser device (10) is arranged to comprise an active section (10-2) having the second grating section (16-2) for providing a DFB transmission functionality (DFB = distributed feedback) of the laser device (10) for the generated laser light (L).

8. The laser device (10) of claim 7, wherein the active section (10-2) with the second grating section (16-2) is arranged to provide a transmission spectrum for the generated laser light (L) that is shifted to longer wavelengths when compared to the reflection spectrum of the reflection section with the first grating section (16-1).

9. The laser device (10) of any of the preceding claims, wherein the contact structure (24, 26) comprises contact regions (24-1, 26-1) arranged on opposing main surface regions of the active section (10-2).

10. The laser device (10) of any of the preceding claims, wherein the cladding structure (18) comprises a semiconductor material, wherein a conductivity type of the semiconductor substrate (14) is opposite to a conductivity type of the semiconductor material of the cladding structure (18).

11. The laser device (10) of any of the preceding claims,
wherein the semiconductor substrate (14) comprises at least one of InP, GaAs, Si, SiC, SiNx and thin film lithium niobate,
and/or
wherein the active layer structure (12) comprises at least one of an InGaAsP (QW)/ InGaAsP (barrier) multi-quantum well, MQW, an InGaAlAs (QW)/ InGaAlAs (barrier) MQW, an InGaAsP (QW) /InGaAlAs (barrier) MQW, InAs multi-quantum dot, MQD and an InAs MQDash material.

12. The laser device (10) of any of the preceding claims, further comprising:
at least one semiconductor optical amplifier (SOA) section arranged on the active layer structure (12) between the second grating structure (16-2) and the corresponding facet (22).

13. A laser arrangement (50), comprising:
the laser device (10) of any of the preceding claims,
wherein the laser device (10) is monolithically integrated with at least one of an electro-absorption modulator (EAM), a semiconductor optical amplifier (SOA), an electro-absorption modulator and a semiconductor optical amplifier (SOA), a Mach-Zehnder modulator (MZM), or a photonic integrated circuit,
and/or
wherein the the laser device (10) is hybridly integrated with a photonic integrated circuit.

14. A method (100) for manufacturing a laser device (10), the method comprising:
arranging (110) an active layer structure on a semiconductor substrate,
integrally (120) forming a grating structure on the active layer structure
such that the integrally formed grating structure comprises a first grating section and a second grating section which are arranged laterally adjacent to each other, which commonly share the active layer structure, and which have the same uniform grating period, wherein the first and second grating sections of the integrally formed grating structure each comprise an index coupling grating; and wherein the first grating section is arranged to have a first effective coupling coefficient and the second grating section is arranged to have a second effective coupling coefficient, wherein the second effective coupling coefficient is smaller than the first effective coupling coefficient;
arranging (130) a cladding structure on the integrally formed grating structure such that the integrally formed grating structure is arranged between the active layer structure and the cladding structure;
arranging (140) a first facet and a second facet arranged at laterally opposing ends of the active layer structure wherein the first facet and the second facet each comprise an anti-reflection coating; and
arranging (150) a contact structure, wherein the contact structure comprises (at least) two contact regions arranged on (vertically) opposing main surface regions of an active section of the laser device.

15. Method (100) of claim 14, further comprising:
forming the first and the second grating section to have the same uniform grating period for providing, during an operating condition of the laser device, a laser light which is in the active layer structure along the first and the second grating section in phase.

16. The method (100) of claim 14 or 15,
wherein the integrally formed grating structure is obtained by a common or single electron beam writing process,
and/or
wherein the integrally formed grating structure is defined within a single electron beam (Ebeam) grating field.
